Europäisches Patentamt

European Patent Office

Office européen des brevets

(11) Publication number: **0 289 246**

**A1**

(12) **EUROPEAN PATENT APPLICATION**

(21) Application number: 88303695.6

(22) Date of filing: 25.04.88

(51) Int. Cl.⁴: **H01L 21/316 , H01L 21/205**

(30) Priority: 27.04.87 JP 103700/87
15.05.87 JP 119540/87

(43) Date of publication of application:
**02.11.88 Bulletin 88/44**

(84) Designated Contracting States:
**DE FR GB**

(71) Applicant: SEIKO INSTRUMENTS INC.
**31-1, Kameido 6-chome Koto-ku
Tokyo 136(JP)**

(72) Inventor: **Aoki, Kenji**
c/o Seiko Instruments Inc. 31-1 Kameido
6-chome
Koto-tu Tokyo(JP)

(74) Representative: **Caro, William Egerton et al
J. MILLER & CO. Lincoln House 296-302 High
Holborn
London WC1V 7JH(GB)**

(54) Method of manufacturing MOS devices.

(57) A MOS device, in particular, a field effect transistor, is manufactured by growing an epitaxial layer to form a channel region on a heavily doped semiconductor substrate by the introduction of dichlorosilane and hydrogen into a grwoth chamber with the substrate at a temperature below 850°C. When the epitaxial growth is completed, a gate insulating film is formed on the epitaxial layer by chemical vapour deposition, nitrous oxide replacing the hydrogen for this formation. The two steps are consecutive and without interruption therebetween.

EP 0 289 246 A1

F I G. 5

## METHOD OF MANUFACTURING MOS DEVICES

The present invention relates to methods of manufacturing MOS devices, and particularly, but not exclusively, MOS field effect transistors (hereinafter referred to as MOSFETs). MOSFETs are used as basic devices in semiconductor integrated circuits and operate at high speed with low power consumption.

It has become possible recently to form with precision a single crystal thin film with a thickness of the order of a monoatomic layer at low temperature due to progress in crystal growth techniques, such as molecular beam epitaxial growth methods (hereinafter called "MBE") and molecular layer epitaxial growth methods (hereinafter called "MLE"). For instance, a report on MBE is described in "Applied Physics", Volume 51, No. 8 (1982), pages 938 - 941, and MLE is discussed in "Semiconductor World", 1985, 1, pages 135 - 140.

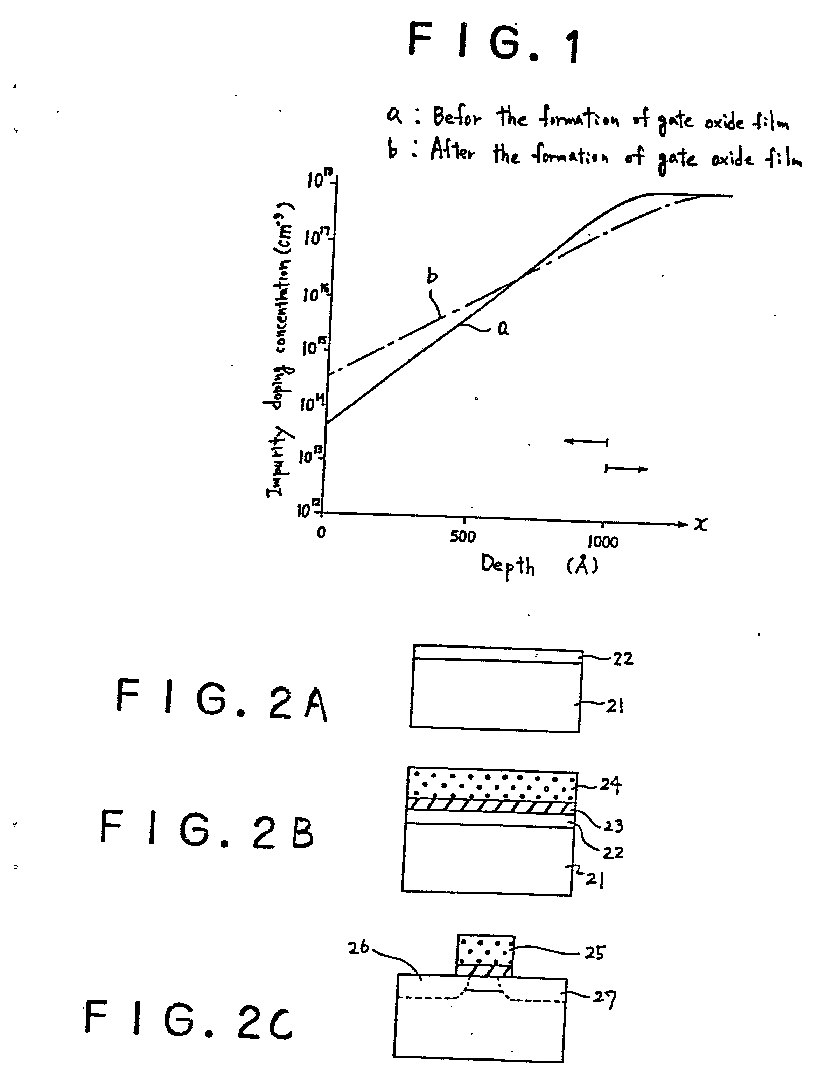

Curve $\underline{a}$ in Figure 1 shows impurity concentration distribution when an epitaxial growth layer of about 1,000 Å thick is formed by MBE at a substrate temperature of 850°C on a high concentration substrate having an impurity concentration of 1 x $10^{18}$ cm$^{-3}$.

In Figure 1, the abscissa $\underline{x}$ represents the thickness which is positive in the direction of depth with the surface of the epitaxial growth layer being zero (0). However, the impurity concentration distribution of the epitaxial growth layer after a gate oxide film of about 300 Å thickness is formed by thermal oxidation at 1000°C for 10 minutes, is such as is represented by curve $\underline{b}$. This curve shows that a high concentration impurity layer is formed by auto-doping of an impurity from the substrate. Therefore, the impurity concentration of the channel region becomes too high and mobility drops effectively.

In the conventional technique, when an epitaxial growth layer having a low concentration impurity layer is formed on a heavily doped substrate by use of MBE or MLE, a high concentration impurity layer is formed on the epitaxial growth layer by auto-doping from the heavily doped substrate, and the thickness of the epitaxial layer is substantially reduced.

In the conventional production of MOSFETs an epitaxial growth layer with low impurity doping concentration is formed on a heavily doped substrate to form a channel region, and then a gate oxide film is formed thereon by thermal oxidation.

In one example of the conventional production of MOSFETs, the gate oxide film is formed by effecting epitaxial growth to form the channel and then carrying out a washing step. In another example, epitaxial growth is first effected on a substrate to form a channel region and then the steps of element isolation, etching and washing are carried out to form the gate oxide film. As described above, in accordance with prior art techniques, the formation step of the channel region and that of the gate oxide film are not consecutive steps but other steps, such as element isolation and chemical washing, are interposed between them.

The interface condition between the channel surface and the gate oxide film is generally extremely important to determine the performance of MOSFETs. However, in accordance with the prior art techniques, the formation step of the channel region is carried out inside the epitaxial growth system, while the formation step of the gate oxide film is carried out inside the thermal oxidation furnace and the etching step, the washing step and the like are interposed between these steps, as described above. Accordingly, the prior art techniques are not free from problems that ions such as Na$^{+}$ deposit on the active channel surface before the formation of the gate oxide film, and that mobile ions are easily incorporated into the oxide film during the oxidation step because the formation step of the oxide film has been made conventionally in an atmosphere of from atmospheric pressure to about 1 Pa.

The present invention seeks to provide a method of manufacturing MOS semiconductor devices (in particular field effect transistors) by which the above mentioned defect of conventional techniques is overcome, and produces a device structure which is highly resistant to latch-up, is effective in preventing short channel effect and has high mobility.

Another aim of the present invention is to provide a method of manufacturing a MOS field effect transistor which has a gate oxide film having extremely good interface condition and film qualities.

In accordance with the present invention, there is provided a method of manufacturing an MOS device characterised by the consecutive steps of forming an epitaxial layer to form a channel region on a heavily doped semiconductor substrate, and forming a gate insulating film on the epitaxial layer by means of chemical vapour deposition.

According to another aspect of the present invention, a method of manufacturing an MOS field effect transistor, comprises the steps of forming a epitaxial layer to form a channel region on a heavily doped semiconductor substrate at a substrate temperature below 850°C, and forming a gate insulating film on the epitaxial layer by means of chemical vapour deposition.

The invention extends to MOS devices made by a manufacturing method according to the invention.

Embodiments of the invention are hereinafter particularly described with reference to the accompanying drawing, in which:-

Figure 1 is a diagram showing the change of the impurity concentration in the channel region of a convention MOSFET whose gate oxide film is formed by thermal oxidation;

Figures 2A to 2C are sectional views showing the stepwise fabrication process of a MOSFET in accordance with one embodiment of the present invention;

Figure 3 is a diagram showing an impurity concentration distribution in the channel region of a MOSFET. made in accordance with the present invention;

Figures 4A to 4D are sectional views showing the stepwise fabrication process of a MOSFET in accordance with another embodiment of the present invention; and

Figure 5 is a diagram illustrating gas introduction during the operations resulting in the structure shown in Figure 4C.

The described embodiments of the present invention effect epitaxial growth on a heavily doped substrate at a low temperature by use of a crystal growth process, such as MBE or MLE, to form a channel region having a low impurity concentration, and prevent diffusion of an impurity from the heavily doped substrate into the channel region by reducing the substrate temperature at the time of formation of a gate oxide film by use of a CVD process.

When the gate oxide film of a MOSFET is formed, the described embodiments of the present invention employ CVD in place of thermal oxidation that has been used, form the gate oxide film at a temperature below 850°C, prevent diffusion of the impurity from the heavily doped substrate into the channel region and thus accomplish high mobility while keeping the impurity concentration of the channel region at a low level. Accordingly, the epitaxial growth layer is a thin epitaxial layer where auto-doping is greatly reduced, and therefore, a high speed semiconductor element can be fabricated easily. In preferred embodiments of the present invention, the step of forming a channel region of MOSFET by growing a single crystal thin film on a semiconductor substrate by epitaxial growth and the step of forming a gate insulating film on the single crystal thin film are carried consecutively inside the same system. Therefore, during operation of preferred embodiments of the present invention, at least one kind of gas among those gases which are used for the epitaxial growth of the channel region is changed to a gas containing a component element of the gate insulating film, and thus epitaxial growth and CVD (chemical vapour deposition) are carried out consecutively.

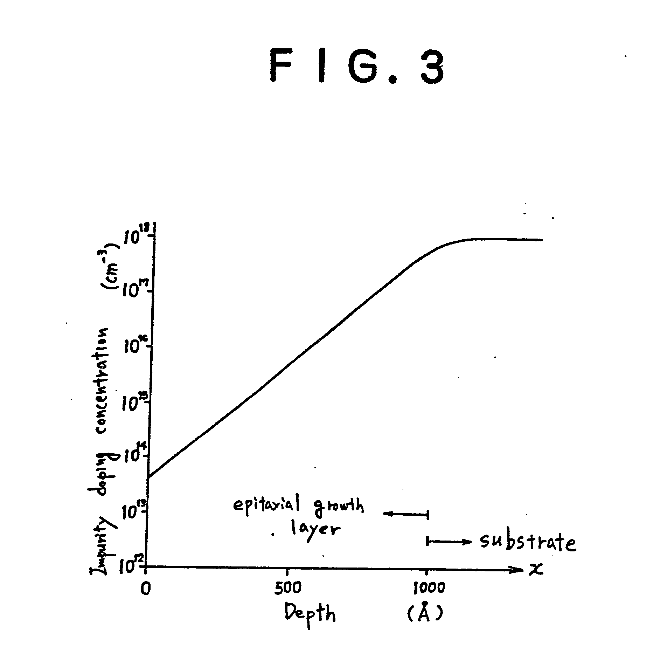

In the fabrication of a MOSFET (Figures 2A, 2B and 2C) in accordance with one embodiment of the present invention, a low concentration epitaxial growth layer 22 (Figure 2A) is formed on a heavily doped substrate 21 at a substrate temperature below 850°C. After the epitaxial growth layer 22 is formed, the substrate is set into a hot wall type reduced pressure CVD system. A satisfactory gate oxide film 23 (Figure 2B) can be obtained by use of dichlorosilane ($SiH_2Cl_2$) and nitrous oxide ($N_2O$) as the material gases for forming the gate oxide film 23 and by setting a gas pressure and a gas flow rate to the optimum conditions while keeping the substrate temperature at 800°C. If the gate oxide film 23 is thus formed, the diffusion of the impurity from the high concentration substrate 21 into the low concentration epitaxial growth layer 22, that otherwise occurs when the oxide film is formed in accordance with the conventional thermal oxidation method, can be limited to a level which can be substantially neglected, and the channel region having a low impurity concentration can be formed on the high concentration substrate, as shown in Figure 3. The abscissa $x$ in Figure 3 represents a positive value in the direction of depth with the surface of the epitaxial growth layer being 0.

In a modification of this method, the gate insulating film may be formed at a substrate temperature somewhat lower than that for the growth of the epitaxial layer.

Thereafter, polycrystalline silicon is deposited to form a gate layer 24 (Figure 2B) and after patterning of the gate 25 (Figure 2C), a source 26 and a drain 27 are formed by ion implantation.

When the low concentration epitaxial growth thin film formed on the heavily doped substrate is used as the channel region, diffusion of the impurity from the substrate into the channel region at the time of formation of the gate oxide film is prevented as described above. Therefore, the impurity concentration of the channel region can be lowered sufficiently even after the formation of the gate oxide film, and for this reason, a MOSFET made in accordance with the method of the present invention is characterised by high speed operation. Furthermore, it carries high latch-up resistance and is effective in preventing a short channel effect.

Particularly, when the step of forming an epitaxial growth layer to form a channel region of a MOSFET and the step of forming a gate insulating film on the epitaxial growth layer are carried out consecutively inside the same apparatus, the following method may be employed. By using an apparatus equipped with a mechanism for introducing a gas used for forming a channel region of a MOSFET by epitaxial growth and a gas used for forming a gate oxide film by CVD and with an exhaust system capable of evacuating the background pressure inside a growth chamber to below $1 \times 10^{-6}$ Pa, the present arrangement effects epitaxial growth for forming the channel region inside the same growth chamber and, simultaneously with completion of the epitaxial growth, exchanges at least one kind of gas among the gases which are used for the epitaxial growth for a gas containing a component element of the gate oxide film, and thereafter proceeds to a CVD step for forming the gate oxide film. In this manner, the present embodiment carries out consecutively the formation of the channel region and the formation of the gate insulating film. In this case, however, the common gas used for epitaxial growth and for the formation of the insulating film is preferably trichlorosilane ($SiHCl_3$) or dichlorosilane ($SiH_2Cl_2$), in which Si does not directly precipitate at a substrate temperature of 900°C or below.

When the channel region and the gate oxide film are formed consecutively in a clean atmosphere whose background pressure is below $1 \times 10^{-6}$ Pa when no gas is introduced, a gate oxide film having an extremely good interface condition and film qualities can be formed at a low temperature on the channel region having excellent crystallinity. Moreover, the fabrication process can be simplified because the formation of the channel region and the formation of the gate oxide film are carried out consecutively inside the same growth chamber.

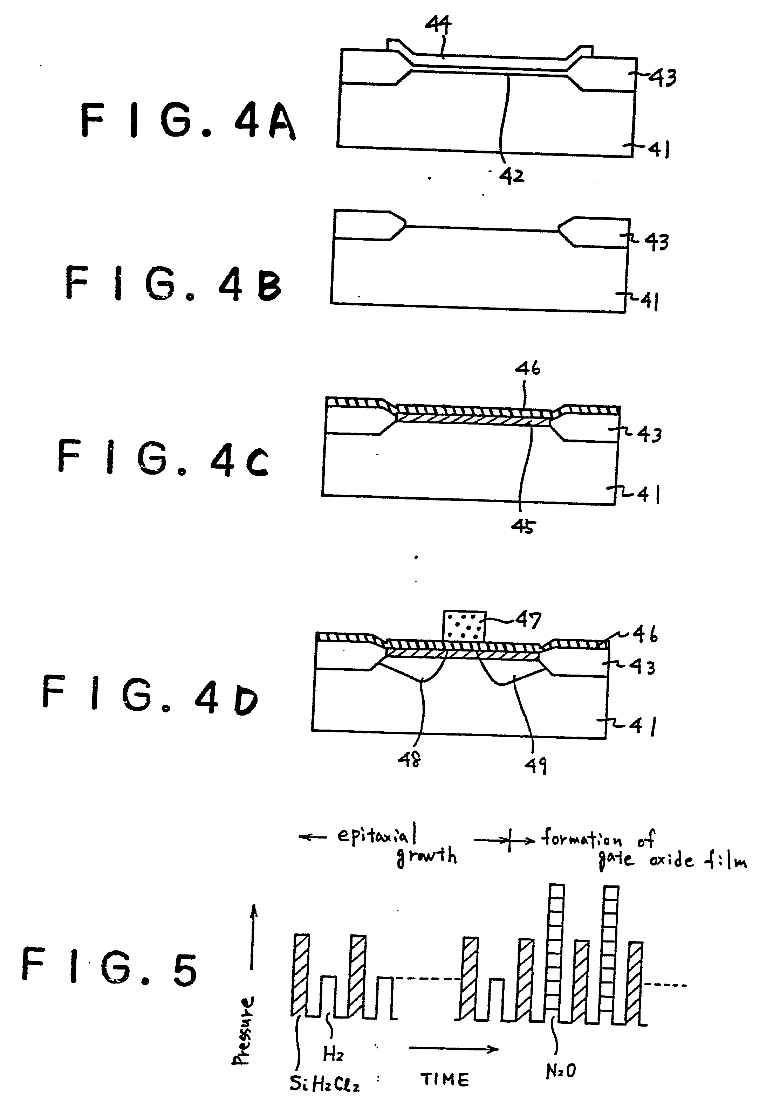

In another embodiment (Figures 4A to 4D) of the present invention, a pad oxide film 42 (Figure 4A) and a silicon nitride film 44 are deposited on a substrate 41, and then a field oxide film 43 is deposited using the silicon nitride film 44 as the mask for element isolation. Next, etching of the silicon nitride film 44 and the pad oxide film 42 is completed (Figure 4B). Then the substrate 41 is set into a growth chamber of the system. The vacuum inside the growth chamber is checked as being below $1 \times 10^{-6}$ Pa before introduction of gas, and the channel region is first formed by epitaxial growth in accordance with the following method.

While a vacuum pressure below $1 \times 10^{-6}$ Pa is maintained, the temperature is raised to about 850°C and the surface of the substrate 41 is cleaned. Then, the substrate temperature is set to 800°C and dichlorosilane ($SiH_2Cl_2$) and hydrogen ($H_2$) are introduced into the growth chamber so that its internal pressure is from 10 to $10^{-3}$ Pa and the epitaxial growth is then carried out. In this case, dichlorosilane and hydrogen are introduced for a predetermined period at respective constant pressures either simultaneously or alternately as illustrated in Figure 5. The introduction of hydrogen among the gases used for the epitaxial growth is stopped at the stage where a single crystal having a desired film thickness has grown, and nitrous oxide ($N_2O$) is introduced in place of hydrogen and CVD is then carried out by use of dichlorosilane and nitrous oxide in order to form the gate oxide film. In this manner, the epitaxial growth layer 45 and the gate oxide film 46 are formed sequentially and continuously (Figure 4C). In this case, dichlorosilane and nitrous oxide are introduced for a predetermined period at respective constant pressures either simultaneously or alternately as illustrated in Figure 5, so that the pressure inside the growth chamber reaches 10 to $10^{-3}$ Pa. The introduction of all the gases is stopped at the stage where the gate oxide film having a desired thickness has been formed, and the substrate temperature is lowered. Thus, the stepwise fabrication process of MOSFETs in accordance with the present invention is characterised in that the epitaxial growth for forming the channel region and the chemical vapour deposition of the oxide film for forming the gate insulating film are carried out consecutively.

In the manner described above, an epitaxial growth layer having excellent crystallinity and a gate oxide film having high film quality and excellent interface characteristics can be formed consecutively each with a precision layer of a thickness of the order of a monoatomic layer. Thereafter, a gate layer 47 is added and then a source 48 and a drain 49 are formed (Figure 4B).

Ion implantation for forming source and drain regions may be carried out before the formation of the epitaxial growth layer.

As in the case of the first embodiment, this other embodiment may be modified so that the gate insulating film is formed at a substrate temperature lower than that for epitaxial layer growth.

In accordance with the arrangement described above, it has now become possible to eliminate completely the necessity of the cleaning step before film formation, that was previously indispensable to the prior art technique when forming the gate oxide film of a MOSFET, and the problem resulting from washing can be obviated. Because the epitaxial growth and gate oxide film CVD are carried out consecutively in a clean atmosphere, a gate oxide film which gives ideal MOS characteristics is formed on the channel having excellent crystallinity. Thus, the present invention improves MOSFET performance. Furthermore, the same effect can be obtained by the use of the present invention in memory devices having a MOS structure.

## Claims

1. A method of manufacturing a MOSFET characterised by the consecutive steps of forming an epitaxial layer (22;45) to form a channel region on a heavily doped semiconductor substrate, and forming a gate insulating film (23;46) on the epitaxial layer (22;45) by means of chemical vapour deposition.

2. A method as claimed in claim 1, characterised in that the epitaxial layer (22;45) is formed by using gases and the gate insulating film (23;46) is formed by changing at least one kind of gas among the gases used for forming the epitaxial layer to a gas containing a component element of a gate insulating film, whereby the epitaxial layer and the gate insulating film are formed consecutively.

3. A method as claimed in claim 2, characterised in that the epitaxial layer (22;45) is grown by using $SiH_2Cl_2$ and $H_2$ gas, and the gate insulating film (23;46) is used by using $SiH_2Cl_2$ gas and $N_2O$ gas.

4. A method as claimed in claim 2 or claim 3 characterised in that the epitaxial layer (22;45) and the gate insulating film (23;46) are formed consecutively in an apparatus having a growth chamber whose background pressure is below $1 \times 10^{-6}$ Pa.

5. A method as claimed in any preceding claim characterised in that the epitaxial layer (22;45) is formed at a substrate temperature below 850°C.

6. A method as claimed in any preceding claim characterised in that the gate insulating film (23;46) is formed at a substrate temperature of below 850°C.

7. A method as claimed in any preceding claim characterised in that the gate insulating film (23;46) is formed at a substrate temperature lower than that for the growth of the epitaxial layer (22;45).

8. A method as claimed in any preceding claim characterised in that the epitaxial layer and the gate insulating film are formed with a precision level of thickness of the order of a monoatomic layer.

9. A method as claimed in any preceding claim characterised in that the device is a field effect transistor.

10. A method of manufacturing a MOS field effect transistor comprising the steps of forming an epitaxial layer to form a channel region on a heavily doped semiconductor substrate at a substrate temperature below 850°C, and forming a gate insulating film or the epitaxial layer by means of chemical vapour deposition.

11. A MOS device made by a manufacturing method as claimed in any preceding claim.

0 289 246

# F I G. 1

a : Befor the formation of gate oxide film
b : After the formation of gate oxide film

F I G. 2 A

F I G. 2 B

F I G. 2 C

0 289 246

# F I G. 3

FIG. 4A

FIG. 4B

FIG. 4C

FIG. 4D

FIG. 5

Pressure

← epitaxial growth → | → formation of gate oxide film

$SiH_2Cl_2$

$H_2$

TIME

$N_2O$

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-4 002 512 (M.-J. LIM) <br> * abstract; figure 5; column 2, lines 43-51; column 3, lines 1-5; column 5, lines 8-43; column 8, lines 38-63 * <br> --- | 1-11 | H 01 L 21/316 <br> H 01 L 21/205 |
| Y | JOURNAL OF APPLIED PHYSICS, vol. 57, no. 8, part 1, April 1985, pages 2956-2959, Woodbury, New York, US; A. ISHITANI et al.: "Epitaxial growth of silicon with Hg-Xe lamp light irradiation" <br> * abstract, page 2956, column 1, paragraph 2 * <br> --- | 1-11 | |
| Y | JAPANESE JOURNAL OF APPLIED PHYSICS, vol. 25, no. 4, part 2, April 1986, pages L297-L298, Tokyo, JP; M. TAKEYASU et al.: MOCVD growth of GaAs0.6P0.4 on Si substrate" <br> * whole document * <br> --- | 1-11 | |
| A | GB-A-2 061 243 (PHILIPS ELECTRONIC AND ASSOCIATED IND.) <br> * column 1, lines 5-19; figure 2; abstract * <br> --- | 1,9,11 | **TECHNICAL FIELDS SEARCHED (Int. Cl.4)** <br><br> H 01 L 21/00 <br> C 23 C 16/00 |
| A | US-A-4 592 792 (J.F. CORBOY) <br> * column 2, lines 62-68; column 3, lines 1-55 * <br> ----- | 1,3,10 | |

The present search report has been drawn up for all claims

| Place of search | Date of completion of the search | Examiner |
|---|---|---|
| BERLIN | 07-07-1988 | JUHL A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)